# EUROPEAN PATENT SPECIFICATION

(11) **EP 3 358 746 B1**
(45) Date of publication and mention of the grant of the patent: **31.08.2022**
(21) Application number: 18154593.0
(22) Date of filing: 01.02.2018
(51) Int. Cl.: H03K 17/00

(54) **ASSEMBLY COMPRISING A PRINTED CIRCUIT BOARD AND A COIL SPRING**
ZUSAMMENBAU MIT EINER LEITERPLATTE UND EINER SPRUNGFEDER
ENSEMBLE COMPRENANT UNE PLAQUETTE DE CIRCUITS IMPRIMÉS ET UN RESSORT A SPIRALE

(30) Priority: 03.02.2017 IT 201700011780
(43) Date of publication of application: 08.08.2018
(73) Proprietor: Bitron S.p.A., 10122 Torino (IT)
(72) Inventor: GIORCELLI, Roberto, 10137 Torino (IT)
(74) Representative: Boario, Enrico

(56) References cited:
- WO-A1-2010/005143
- CN-A- 105 070 560
- US-A- 4 458 293
- US-A1- 2016 359 246

## Description

### Technical field

The present invention relates to an assembly comprising a printed circuit board and a coil spring.

### Background art

In the electronics industry, it is known to mount a spring to a printed circuit board (PCB) in order to create various components, such as keys, push-buttons, etc. The spring is intended to operate between the key and the printed circuit board.

It is known to join the spring to the circuit board by soldering. However, this type of connection suffers from some drawbacks, such as, for example, execution difficulty and long execution times. Moreover, the soldered spring cannot be removed from the circuit board.

Other types of connection require the presence of a fixing member whereon the spring is mounted; the fixing member is then mounted to the printed circuit board. Such a solution is expensive and complex, since it requires an additional component for joining together the spring and the circuit.

WO 2010/005143 A1 discloses a variable directional microphone assembly and a method of manufacturing the same, which can achieve miniaturization by mounting microphone devices in a compact structure with a microphone body, and reduce maintenance costs by transmitting a signal through contact using a coil spring for convenient replacement of the microphone device. The variable directional microphone assembly includes a printed circuit board including a connection terminal provided to a surface thereof, and a semiconductor integrated circuit device mounted to another surface thereof, a microphone body including a first mounting space for mounting the semiconductor integrated circuit device, two second mounting spaces, and a coil spring insertion hole, the first mounting space being provided to a surface of the microphone body, the second mounting spaces being provided to another surface of the microphone body, two microphone devices mounted to the second mounting spaces, the insertion hole allowing the microphone device to be in contact with the printed circuit board, a coil spring inserted into the coil spring insertion hole to electrically connect the microphone device to the printed circuit board, and a case including a sound hole in a bottom thereof and configured to fix an assembly by inserting the microphone body coupled with the microphone devices and the semiconductor integrated circuit device into the case and then curling the case.

### Summary of the invention

It is one object of the present invention to provide an assembly comprising a printed circuit board and a coil spring which can overcome this and other drawbacks of the prior art, while at the same time being simple and economical to manufacture.

According to the present invention, this and other objects are achieved through an assembly comprising a printed circuit board and a coil spring made in accordance with the appended independent claim.

A further aspect of the invention concerns the making of a capacitive key including such an assembly.

The appended dependent claims define some preferred embodiments of the present invention, which include some optional technical features.

### Brief description of the drawings

Further features and advantages of the present invention will become apparent from the following detailed description, which is supplied by way of non-limiting example with reference to the annexed drawings, wherein:
- Figure 1 is a perspective view of an assembly in a non-assembled condition, made in accordance with an illustrative embodiment of the present invention;
- Figure 2 shows a detail of Figure 1;
- Figure 3 is a perspective view of the assembly of Figure 1 in an assembled condition;
- Figure 4 is a partial perspective view of an assembly in a non-assembled condition, made in accordance with a further illustrative embodiment of the present invention.

### Detailed description of the invention

With reference to the drawings, there is shown an assembly comprising:
- a printed circuit board 2, and
- a coil spring 4 developing along a longitudinal axis x-x and consisting of a wire 6 that defines a spring body 8 having an inner cavity 10.

At a first end of spring 4, wire 6 forms a fitting portion 12 that, by becoming elastically deformed, is configured for fitting into an aperture 14 of printed circuit board 2, so as to removably secure spring 4 to printed circuit board 2.

Thus, assembling is effected in a simple, quick and removable manner. Furthermore, the assembly is compact and inexpensive, because no additional intermediate elements are required for fastening spring 4 to printed circuit board 2.

Preferably, with reference to a plane perpendicular to the longitudinal axis x-x, wire 6 does not intersect the inner part of spring body 8. In other words, in a projection of spring 4 on a plane perpendicular to the longitudinal axis x-x, no part of wire 6 is located in a more internal position relative to spring body 8. Spring body 8 is formed by the coils of coil spring 4.

Preferably, aperture 14 is a slot. Preferably, aperture 14, in particular the slot, is a through opening, i.e. it goes through both faces of printed circuit board 2.

Printed circuit board 2 (PCB) may be of a *per se* known type, e.g. an electronic board, etc. According to some possible variant embodiments, the assembly comprises a support layer for supporting an electric/electronic circuit whereon spring 4 is mounted, in accordance with the present description. The support layer includes aperture or slot 14. One or more electric/electronic components constituting said electric/electronic circuit are mounted on the support layer.

Coil spring 4 is preferably cylindrical, in particular it has a linear behaviour. Spring body 8 comprises, as is known, a plurality of coils. In this example, the coils are all substantially equal, and spring body 8 is cylindrical. Therefore, cavity 10 is also substantially cylindrical. As an alternative, spring 4, in particular spring body 8, may have different shapes, such as a truncated conical shape. Furthermore, a spring 4 having a non-linear behaviour may be used, e.g. a progressive spring, etc. Spring 4 is preferably made of electrically conductive material, e.g. metal or metal alloy.

Spring 4 has two ends, one of which comprises fitting portion 12. Fitting portion 12, formed by wire 6 that forms spring body 8 as well, is in a distal position relative to spring body 8. In particular, fitting portion 12 is substantially parallel to the longitudinal axis x-x.

According to the invention, fitting portion 12 is configured for mounting spring 4 to printed circuit board 2 in a removable manner. Fitting portion 12 is configured for being inserted into and removed from aperture 14, in particular the slot, by applying a force that causes it to become elastically deformed, so that it can be inserted into and removed from aperture 14. Fitting portion 12 is therefore elastically deformable. It is thus possible to assemble and disassemble spring 4 and printed circuit board 2 by simply pushing and pulling spring 4 onto/from printed circuit board 2 and by applying the necessary force for deforming fitting portion 12. Therefore, no tools or other elements need to be used.

According to the invention, fitting portion 12 has a hook-like shape.

According to the invention, fitting portion 12 comprises a wider portion 16, located in a distal position (i.e. farther from spring body 8), and a narrower portion, located in a proximal position. In particular, the narrower portion comprises two first tracts 18, 20 of wire 6, preferably parallel to each other, and in particular parallel to the longitudinal axis x-x. Wider portion 16 is, therefore, a wire tract connecting the two first tracts 18, 20. In particular, wider portion 16 is curved. Conveniently, wider portion 16 comprises two shoulders 17, 19, located farther away compared to the two first tracts 18, 20. In the illustrated variant, shoulders 17, 19 define the width of wider portion 16, and the two first tracts 18, 20 define the width of the narrower portion.

The width of wider portion 16 slightly exceeds the length of the slot, so that wider portion 16 will become deformed to go through the slot upon exertion of a mechanical force, for the purpose of mounting or dismounting spring 4 onto/from printed circuit board 2.

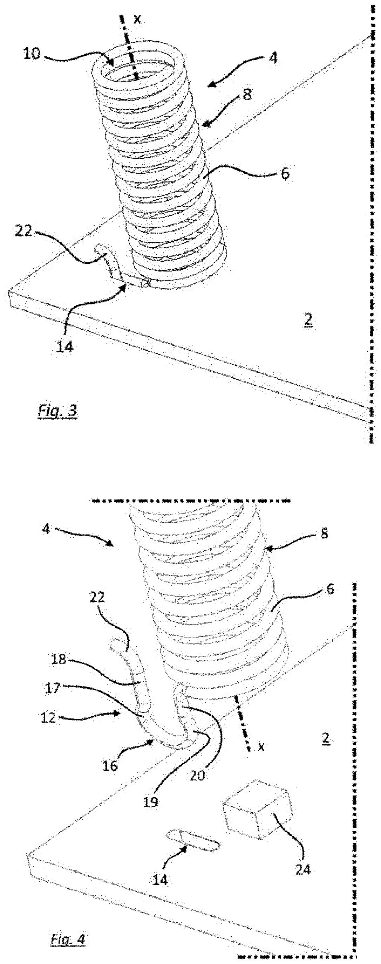

Conveniently, fitting portion 12 comprises a final tract 22 of wire 6, said final tract 22 being configured to limit the insertion of fitting portion 12 into aperture 14. In fact, with reference to Figure 3, when fitting portion 12 is in aperture 14 (in particular the slot), final tract 22 protrudes from printed circuit board 2 on the side whereon spring 4 is located. Moreover, final tract 22 may also act as a gripping portion for a user, who, by gripping final tract 22, can elastically deform fitting portion 12 to promote the extraction or insertion thereof from/into aperture 14.

Preferably, fitting portion 12 lies in a plane, in particular said plane being substantially parallel to the longitudinal axis x-x. In particular, the wire tracts designated by numerals 16, 18, 20, and preferably also the elements designated by numerals 17, 19, 22, lie in that plane. With reference to the preferred example illustrated herein, said plane is tangent to spring body 8.

When viewing spring 4 in a plane perpendicular to the longitudinal axis x-x, spring body 8 defines cavity 10, and fitting portion 12 and the final parts of wire 6 do not fall within spring body 8, i.e. within cavity 10. As aforesaid, a final part of wire 6 forms fitting portion 12. Therefore, cavity 10 is an empty channel that runs through spring 4 parallel to the longitudinal axis x-x.

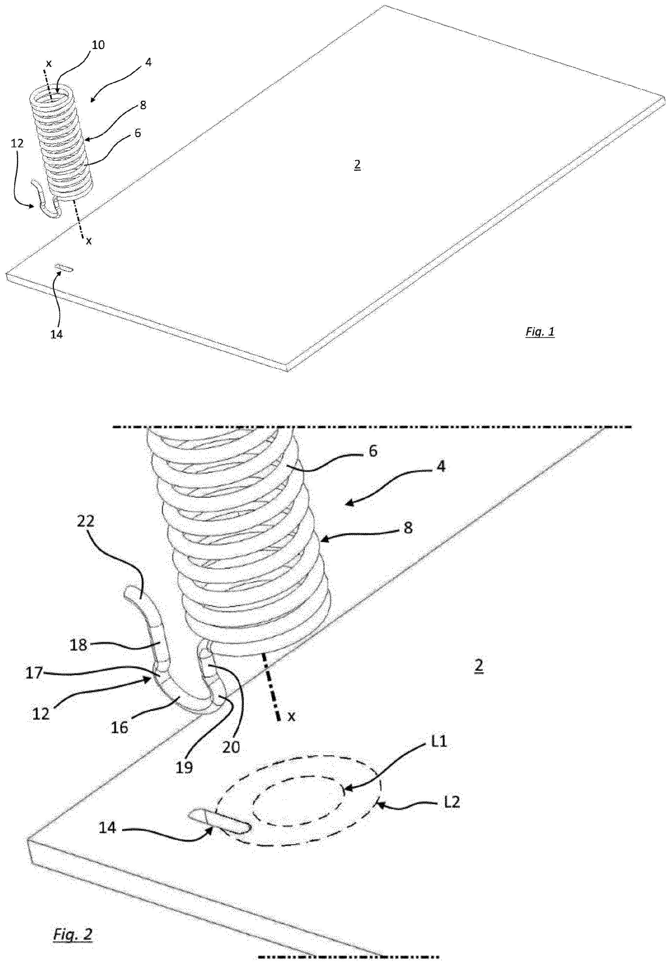

In accordance with a preferred variant, with reference to a plane perpendicular to the longitudinal axis x-x, fitting portion 12 is tangent to spring body 8. In Figure 2, the dashed lines L1, L2 schematically indicate the inner profile and, respectively, the outer profile of the projection of spring body 8 on printed circuit board 2. As can be seen, fitting portion 12 protrudes tangentially outwards from outer profile L2 of spring body 8. In fact, aperture 14, in particular the slot, also protrudes outwards relative to the projection of spring body 8 on printed circuit board 2.

Preferably, printed circuit board 2 is electrically connected to spring 4 when the latter 4 is mounted to printed circuit board 2. For example, fitting portion 12 and/or one or more coils are adapted for coming in contact with an electrically conductive portion, e.g. a metal portion, of printed circuit board 2.

Preferably, with reference to Figure 4, printed circuit board 2 includes an illuminating element 24 capable of emitting light and located within spring body 8, with reference to a plane perpendicular to the longitudinal axis x-x. Illuminating element 24 may be *per se* known, and preferably including a LED, or a bulb. The light beam emitted by illuminating element 24 can pass through cavity 10 without encountering any obstacle. Illuminating element 24 is therefore located near/at the first end of spring 4. This ensures very good visibility of the light emitted by said illuminating element 24 from the second end of spring 4. Preferably, illuminating element 24 is substantially coaxial to the longitudinal axis x-x. In accordance with the preferred variant, the LED is soldered to printed circuit board 2. As far as the assembling steps are concerned, after the LED has been soldered to printed circuit board 2, spring 4 is mounted to said printed circuit board 2. In accordance with one possible alternative variant, illuminating element 24 can be removably secured to printed circuit board 2.

This assembly is advantageous in that it can be associated with a capacitive key, a switch or a button to provide visual feedback for the action executed thereon by the user, e.g. when it is touched or pressed.

In accordance with a further aspect of the invention, a capacitive key is provided comprising:
- an assembly according to the invention, wherein printed circuit board 2 is electrically connected to spring 4;
- an external layer of material having at least partially insulating properties, wherein the external layer is to be touched by a user and is located, e.g. mounted, at a second end of spring 4.

Therefore spring 4, which is made of electrically conductive material, acts as a first armature of a capacitor. When the user touches the external layer, the capacity of said capacitor will change, thus allowing a control unit to determine the presence of a part of the user's body on the external layer, so that predefined actions can be executed in response to that touch. The operation of a capacitive key will not be described any further, since it is *per se* known.

Advantageously, the material of the external layer is an insulating material, e.g. plastic or glass. The external layer serves to avoid any contact between the part of the user's body, e.g. a finger, and spring 4.

According to a particular variant, the external layer comprises an at least partially transparent portion, so that illuminating element 24, when it is emitting light, can be seen by the user through said at least partially transparent portion. Said capacitive key can be integrated into a control panel, which may possibly include other control elements, such as knobs, keys, displays, indicators, etc. The control panel may, for example, be mounted on a household appliance, such as a washing machine, an oven, a refrigerator, etc. It is therefore possible to provide visual feedback about an operating condition of the system with which the capacitive key is associated. Merely by way of example, the light emitted by illuminating element 24 may indicate the on or standby condition of the system (e.g. the household appliance), or it may indicate that a certain operation is being executed, a malfunctioning or faulty condition, or other conditions, according to the case.

## Claims

1. An assembly comprising:
- a printed circuit board (2), and
- a coil spring (4) developing along a longitudinal axis (x-x) and consisting of a wire (6) that defines a spring body (8) having an inner cavity (10);
wherein, at a first end of the spring (4), the wire (6) forms a fitting portion (12) that, by becoming elastically deformed, is adapted for fitting into an aperture (14) of the printed circuit board (2), so as to removably secure the spring (4) to the printed circuit board (2);
**characterized in that** the fitting portion (12) has a hook-like shape, and comprises: a wider portion (16), located in a distal position which is farther from the spring body (8), and a narrower portion, located in a proximal position.

2. Assembly according to claim 1, wherein, with reference to a plane perpendicular to the longitudinal axis (x-x), the wire (6) does not intersect the inner part of the spring body (8).

3. Assembly according to claim 2, wherein the printed circuit board (2) includes an illuminating element (24) adapted for emitting light and located within the spring body (8), with reference to a plane perpendicular to the longitudinal axis (x-x).

4. Assembly according to any one of the preceding claims, wherein the spring (4) has a cylindrical body.

5. Assembly according to any one of the preceding claims, wherein the aperture (14) is a slot.

6. Assembly according to any one of the preceding claims, wherein the fitting portion (12) comprises a final tract (22) of the wire (6), said final tract (22) being configured to limit the insertion of the fitting portion (12) into the aperture (14).

7. Assembly according to any one of the preceding claims, wherein, with reference to a plane perpendicular to the longitudinal axis (x-x), the fitting portion (12) is tangent to the spring body (8).

8. Assembly according to any one of the preceding claims, wherein the spring (4) is made of electrically conductive material, and the printed circuit board (2) is electrically connected to the spring (4) when the latter (4) is mounted to the printed circuit board (2).

9. A capacitive key, comprising:
- an assembly according to claim 8;
- an external layer of material having at least partially insulating properties, wherein said external layer is adapted to be touched by a user and is located at a second end of the spring (4).

10. Key according to claim 9, wherein the assembly is made also in accordance with claim 3 and the external layer comprises an at least partially transparent portion, so that the illuminating element (24), when it is emitting light, can be seen by the user through said at least partially transparent portion.

## Patentansprüche

1. Eine Baugruppe, aufweisend:
- eine Leiterplatte (2), und
- eine Schraubenfeder (4), die sich entlang einer Längsachse (x-x) verläuft und aus einem Draht (6) besteht, der einen Federkörper (8) mit einem inneren Hohlraum (10) bildet;
wobei der Draht (6) an einem ersten Ende der Feder (4) einen Befestigungsabschnitt (12) bildet, der durch elastische Verformung in eine Öffnung (14) der Leiterplatte (2) passt, um die Feder (4) lösbar an der Leiterplatte (2) zu befestigen;
**dadurch gekennzeichnet, dass** der Befestigungsabschnitt (12) eine hakenartige Form hat und aufweist: einen breiteren Abschnitt (16), der sich in einer distalen Position befindet, die weiter vom Federkörper (8) entfernt ist, und einen schmaleren Abschnitt, der sich in einer proximalen Position befindet.

2. Baugruppe nach Anspruch 1, **dadurch gekennzeichnet, dass** der Draht (6), bezogen auf eine Ebene senkrecht zur Längsachse (x-x), den inneren Teil des Federkörpers (8) nicht schneidet.

3. Baugruppe nach Anspruch 2, **dadurch gekennzeichnet, dass** die Leiterplatte (2) ein Leuchtelement (24) enthält, das Licht emittieren kann und sich im Inneren des Federkörpers (8) befindet, bezogen auf eine Ebene, die senkrecht zur Längsachse (x-x) verläuft.

4. Baugruppe nach einem der vorhergehenden Ansprüche, wobei die Feder (4) einen zylindrischen Körper aufweist.

5. Baugruppe nach einem der vorhergehenden Ansprüche, wobei die Öffnung (14) ein Schlitz ist.

6. Baugruppe nach einem der vorangehenden Ansprüche, wobei der Befestigungsabschnitt (12) einen Endabschnitt (22) des Drahtes (6) aufweist, wobei der Endabschnitt (22) so konfiguriert ist, dass er das Einführen des Befestigungsabschnitts (12) in die Öffnung (14) begrenzt.

7. Baugruppe nach einem der vorangehenden Ansprüche, bei der, bezogen auf eine Ebene senkrecht zur Längsachse (x-x), der Befestigungsabschnitt (12) den Federkörper (8) tangiert.

8. Baugruppe nach einem der vorhergehenden Ansprüche, wobei die Feder (4) aus elektrisch leitendem Material besteht und die Leiterplatte (2) mit der Feder (4) elektrisch verbunden ist, wenn diese (4) an der Leiterplatte (2) angebracht ist.

9. Kapazitive Taste, aufweisend
- eine Baugruppe nach Anspruch 8;
- eine äußere Schicht aus einem Material mit zumindest teilweise isolierenden
Eigenschaften, wobei die äußere Schicht so beschaffen ist, dass sie von einem Benutzer berührt werden kann, und sich an einem zweiten Ende der Feder (4) befindet.

10. Taste nach Anspruch 9, wobei die Baugruppe auch nach Anspruch 3 hergestellt ist und die äußere Schicht einen zumindest teilweise transparenten Abschnitt aufweist, so dass das Leuchtelement (24), wenn es Licht ausstrahlt, vom Benutzer durch den zumindest teilweise transparenten Abschnitt gesehen werden kann.

## Revendications

1. Ensemble comprenant :
- une carte de circuit imprimé (2), et
- un ressort hélicoïdal (4) se développant le long d'un axe longitudinal (x-x) et constitué d'un fil (6) qui définit un corps de ressort (8) ayant une cavité intérieure (10) ;
dans lequel, à une première extrémité du ressort (4), le fil (6) forme une partie d'installation (12) qui, en se déformant élastiquement, est adaptée pour s'installer dans une ouverture (14) de la carte de circuit imprimé (2), de manière à fixer de façon amovible le ressort (4) à la carte de circuit imprimé (2) ;
**caractérisé en ce que** la partie d'installation (12) a une forme de type crochet, et comprend : une partie plus large (16), située dans une position distale qui est plus éloignée du corps de ressort (8), et une partie plus étroite, située dans une position proximale.

2. Ensemble selon la revendication 1, dans lequel, en référence à un plan perpendiculaire à l'axe longitudinal (x-x), le fil (6) n'entrecoupe pas la partie intérieure du corps de ressort (8).

3. Ensemble selon la revendication 2, dans lequel la carte de circuit imprimé (2) comprend un élément éclairant (24) adapté pour émettre de la lumière et situé à l'intérieur du corps de ressort (8), en référence à un plan perpendiculaire à l'axe longitudinal (x-x).

4. Ensemble selon l'une quelconque des revendications précédentes, dans lequel le ressort (4) a un corps cylindrique.

5. Ensemble selon l'une quelconque des revendications précédentes, dans lequel l'ouverture (14) est une fente.

6. Ensemble selon l'une quelconque des revendications précédentes, dans lequel la portion d'installation (12) comprend un tronçon final (22) du fil (6), ledit tronçon final (22) étant configuré pour limiter l'insertion de la partie d'installation (12) dans l'ouverture (14).

7. Ensemble selon l'une quelconque des revendications précédentes, dans lequel, en référence à un plan perpendiculaire à l'axe longitudinal (x-x), la portion d'installation (12) est tangente au corps de ressort (8).

8. Ensemble selon l'une quelconque des revendications précédentes, dans lequel le ressort (4) est constitué d'un matériau électriquement conducteur, et la carte de circuit imprimé (2) est reliée électriquement au ressort (4) lorsque ce dernier (4) est monté sur la carte de circuit imprimé (2).

9. Clé capacitive, comprenant :
- un ensemble selon la revendication 8 ;
- une couche externe de matériau ayant des propriétés au moins partiellement isolantes, dans lequel ladite couche externe est adaptée pour être touchée par un utilisateur et est située à une seconde extrémité du ressort (4).

10. Clé selon la revendication 9, dans laquelle l'ensemble est réalisé également selon la revendication 3 et la couche externe comprend une partie au moins partiellement transparente, de sorte que l'élément éclairant (24), lorsqu'il émet de la lumière, peut être observé par l'utilisateur à travers ladite partie au moins partiellement transparente.
